Europäisches Patentamt

European Patent Office

Office européen des brevets

(11) Veröffentlichungsnummer: **0 347 567**
**A2**

(12) **EUROPÄISCHE PATENTANMELDUNG**

(21) Anmeldenummer: **89108113.5**

(22) Anmeldetag: **05.05.89**

(51) Int. Cl.⁴: **H01J 37/34 , C23C 14/34**

(30) Priorität: **23.06.88 DE 3821207**

(43) Veröffentlichungstag der Anmeldung:
**27.12.89 Patentblatt 89/52**

(84) Benannte Vertragsstaaten:
**AT BE CH DE ES FR GB IT LI LU NL SE**

(71) Anmelder: **LEYBOLD AKTIENGESELLSCHAFT**
**Wilhelm-Rohn-Strasse 25**
**D-6450 Hanau 1(DE)**

(72) Erfinder: **Scherer, Michael Dr. Dipl.-Phys.**
**Lindenstrasse 12**
**D-6458 Rodenbach(DE)**
Erfinder: **Latz, Rudolf, Dr. Dipl.-Phys.**
**Mainzer Landstrasse 326**
**D-6000 Frankfurt(DE)**
Erfinder: **Patz, Ulrich, Dr.**
**Waldstrasse 26**
**D-6464 Linsengericht 2(DE)**

(74) Vertreter: **Schickedanz, Willi, Dipl.-Ing.**
**Langener Strasse 68**
**D-6050 Offenbach/Main(DE)**

(54) **Anordnung zum Beschichten eines Substrats mit Dielektrika.**

(57) Die Erfindung betrifft eine Anordnung zum Beschichten eines Substrats (1) mit Dielektrika, die eine Gleichstromquelle (10) aufweist, welche mit einer Elektrode (5) verbunden ist, die elektrisch mit einem Target (3) in Verbindung steht, das zerstäubt wird. Die zerstäubten Teilchen des Targets (3) gehen mit einem zugeführten Stoff eine Verbindung ein, die sich auf dem Substrat (1) niederschlägt. Durch das Target (3) greifen toroidförmige Magnetfelder hindurch, deren Feldlinien im Bereich von Magnetpolen aus der Oberfläche des Targets (3) heraustreten. Erfindungsgemäß ist eine Wechselspannungsquelle (30) vorgesehen, deren Ausgangsspannung der Gleichspannung der Gleichstromquelle (10) überlagert ist. Hierbei entspricht die elektrische Leistung der Wechselstromquelle (30), die der Elektrode (5) zugeführt wird, 5 % bis 25 % der von der Gleichstromquelle (10) der Elektrode (5) zugeführten Leistung.

FIG.1

## ANORDNUNG ZUM BESCHICHTEN EINES SUBSTRATS MIT DIELEKTRIKA

Die Erfindung betrifft eine Anordnung zum Beschichten eines Substrats mit Dielektrika.

Die Beschichtung von Substraten mit Metallen mit Hilfe des Sputter- oder Zerstäubungsverfahrens ist relativ einfach, weil Metalle gute elektrische Leiter sind. Wesentlich schwieriger ist es, Substrate mit Oxidschichten zu versehen, die keine oder nur eine sehr geringe elektrische Leitfähigkeit besitzen. Um trotz dieser Schwierigkeit auch Oxide und andere Dielektrika auf einem Substrat niederschlagen zu können, erzeugt man über das Gleichstrom-Sputtern Metallpartikel, die dann in einer reaktiven Atmosphäre in Oxide umgewandelt und auf dem Substrat niedergeschlagen werden.

Das Umwandeln der Metallpartikel in Oxide geschieht hierbei in der unmittelbaren Nähe des Substrats und im Abstand von der Zerstäubungskathode, um zu vermeiden, daß sich auf dieser Kathode ebenfalls Oxide niederschlagen, was eine Abnahme der Zerstäubungsrate zur Folge hätte. Trotzdem ist es in der Praxis nicht möglich, die Kathode vollständig von Oxiden freizuhalten, so daß die Zerstäubungsrate allmählich erheblich sinkt.

Wird das Sputtern oder Zerstäuben mittels Magnetronkathoden durchgeführt, so tritt das Problem auf, daß dort, wo die magnetischen Feldlinien ihr Krümmungsmaximum haben, am intensivsten zerstäubt wird, so daß ein Sputtergraben entsteht. Die intensive Zerstäubung an diesen Stellen verhindert, daß sich Oxide niederschlagen können. Auf denjenigen Bereichen des Targets, die nicht oder nur sehr langsam abgesputtert werden, bilden sich jedoch unter dem Einfluß von Reaktivgasen nichtleitende, dielektrische Beläge aus. Diese wachsenden Bereiche laden sich elektrostatisch auf, sind Ausgangspunkte von spontanen Überschlägen auf der Targetoberfläche und als Folge davon von Überschlägen zwischen Target und Plasma bzw. Target und der das Target umgebenden Masse. Während dieser Überschläge muß der Kathodenstrom kurzzeitig zurückgenommen werden, damit der Entladungsbogen gelöscht wird, was jedoch weitere Instabilitäten nach sich zieht, bis die Entladung schließlich völlig zum Erliegen kommt.

Beim Gleichstrom-Magnetronsputtern kann im Gegensatz zum reinen Diodensputtern die partielle Belegung des Targets mit Reaktionsprodukten nicht verhindert, sondern allenfalls durch Optimierung des Magnetfeldes kleingehalten werden.

Ein Lösungsansatz für das Problem ergibt sich, wenn anstelle einer Gleichspannung eine Hochfrequenzwechselspannung zwischen Target-Elektrode und Substrat gelegt wird. Bei diesem Hochfrequenz-Magnetronsputtern in reaktiver Atmosphäre treten keine Überschläge auf der Targetoberfläche auf und es ergeben sich keine elektrostatischen Aufladungen. Die Zerstäubungsrate ist jedoch beim reinen Hochfrequenz-Sputtern relativ gering.

Es ist indessen auch bekannt, Tantal und Tantaloxid mittels eines Gleichstrom-Sputterverfahrens auf einem Substrat niederzuschlagen, bei dem der Gleichspannung eine Hochfrequenzspannung überlagert ist (F. Vratny: Deposition of tantalum and tantalum oxide by superimposed RF and DC sputtering; Conference Paper on Thin Film Dielectrics, 7. - 11. Oktober 1968, Reprint aus J. Electrochem. Soc., 114-5, 505, 1967). Das kombinierte Gleichstrom-Wechselstromfeld erhöht die Plasmadichte und verhindert die Bildung eines dielektrischen Films auf der Kathode während des reaktiven Sputterns. Hierdurch ist es möglich, bei Sputterdrücken von 0,5 bis 2 Milli-Torr eine Tantalniederschlagsrate von ca. 80 Å/min zu erreichen bzw. einen doppelten Zuwachs der Tantalniederschlagsrate bei Drücken im Bereich von 10 bis 20 Milli-Torr. Eine Niederschlagsrate von 50 bis 100 Å/min ergibt sich für Beschichtungen aus $Ta_2O_5$ und $MnO_x$ beim reaktiven Sputtern in reinem Sauerstoff.

Die Erhöhung der Niederschlagsrate erklärt sich daraus, daß bei einem angelegten Hochfrequenzfeld die geladenen Teilchen eine oszillatorische Bewegung ausführen. Die Elektronen, die unter dem Einfluß des überlagerten Feldes wandern, legen einen größeren Weg zurück als diejenigen Elektronen, die nur einem Gleichfeld ausgesetzt sind. Der längere Weg vergrößert die Wahrscheinlichkeit von Elektronengas-Atom-Zusammenstößen, was zu einer Zunahme der Stromdichte der positiven Ionen an der Kathode bei einem vorgegebenen Druck führt. Dies wiederum bewirkt eine Vergrößerung der Sputterrate und des Niederschlags einer Schicht. Die Art und Weise, wie die Elektronen im Gas reagieren, hängt von dem Gasdruck oder der freien Weglänge des Elektrons, der Frequenz des Hochfrequenzfeldes und der Anordnung der Elektroden ab. Bei niedrigen Drücken, wenn die mittlere freie Weglänge größer als der Abstand zwischen den Elektroden ist, werden die Elektronen angeregt und durchlaufen den Raum zwischen den Elektroden fast ganz ohne Zusammenstöße mit dem Gas. Beispielsweise haben die Elektronen in Argon bei einer Energie von 0,4 eV mit einem Druck von 10 Milli-Torr eine mittlere freie Weglänge von 10 cm, was etwa dem Abstand herkömmlicher Elektroden entspricht. Bei Drücken, wo die mittlere freie Weglänge eines Elektrons kleiner ist als der Abstand der Elektroden und die Frequenz des Feldes kleiner ist als die Kollisionsfrequenz des Gases, stoßen die Elektronen bei jeder Schwingung mehrfach zusammen und neigen dazu, sich mit der Phase des Felds fortzubewegen. Ein Beispiel hierfür sind das niederfrequente Wechselstromsputtern sowie das niederfrequente Gleichstrom-Wechselstromsputtern, wo die Elektronen nacheinander die Kathode und das Substrat bombardieren. Bei hohen Frequenzen können die Elektronen zwischen den Gas-Kollisionen zahlreiche Schwingungen von kleiner Amplitude ausführen. In diesem Fall erscheint die Elektronenwolke stationär, was in einem intensiven Plasma resultiert, das durch ein überlagertes Gleichfeld abgezogen werden kann. Bei noch höheren Frequenzen, zum Beispiel im Mikrowellenbereich, befinden sich die Elektronen unter dem Einfluß einer stehenden Welle mit elektrischen und magnetischen Komponenten. Aufgrund dieses Einflusses werden die Elektronen im Raum entsprechend den räumlichen Bedingungen verteilt, d. h. in Abhängigkeit von den Elektrodenabmessungen und der Frequenz, welche die stehende Welle erzeugt.

Die Anwesenheit des Hochfrequenzfeldes dient außerdem dazu, eine Ablagerung einer dielektrischen Schicht auf der Kathode während des reaktiven Sputterns mit einem elektronegativen Gas zu verhindern. Da die Ionendichte durch das Hochfrequenzfeld aufrechterhalten werden kann, verringert das Bombardement an der Kathode die Wahrscheinlichkeit der Bildung einer signifikanten Isolatorschicht. Falls eine Isolatorschicht hergestellt werden sollte, würde die hochfrequenzinduzierte Ladung an der Oberfläche den Sputterprozeß aufrechterhalten und außerdem den Isolationsbildungsprozeß verringern. Wegen der höheren Ionisationswahrscheinlichkeit und der Verringerung der Durchbruchstärke des Gases ermöglicht das Hochfrequenzfeld einen Betrieb bei niedrigeren Sputterdrücken, als sie normalerweise beim Diodensputtern auftreten.

Die vorstehend beschriebene bekannte Anordnung bezieht sich auf das Diodensputtern oder -Zerstäuben. Dasselbe gilt auch für eine andere bekannte Einrichtung, bei der eine Gleich- und Wechselspannung an eine Elektrode gelegt werden (Köhler, Coburn, Horne und Kay: Plasma potentials of 13.56-MHz rf argon glow discharges in a planar system, 3. Appl. Physics 57 (1), Januar 1985, S. 59 bis 66). Das Diodensputtern hat jedoch den Nachteil, daß es für zahlreiche Anwendungsfälle eine zu niedrige Niederschlagsrate hat, und zwar auch dann noch, wenn von der Wechselstromüberlagerung Gebrauch gemacht wird. Das oben erwähnte Sputtern mit einer Magnetronkathode ergibt wesentlich höhere Sputterraten.

Es ist auch bekannt, das Magnetron-Sputtern mit einer Mikrowelleneinstrahlung zu kombinieren (US-PS 4 610 770 = EP 0 148 504). Die Mikrowelleneinstrahlung soll hierbei verhindern, daß das Target nur dort abgesputtert wird, wo sich die toroidförmigen Feldlinien der Magnetronelektrode befinden. Die Sputterfläche soll also erheblich vergrößert werden, um die Sputterrate zu erhöhen und um das Target nicht nur in einem eng begrenzten Bereich zu erodieren. Um dieses Ziel zu erreichen, wird ein Spiegelmagnetfeld mit Hilfe von nur zwei Dauermagneten erzeugt, die auf einer gemeinsamen Achse und koaxial zueinander angeordnet sind. Auf diese Weise erhält man eine magnetische Flußverteilung, bei welcher die Linien des magnetischen Flusses sich im Zwischenbereich zwischen den Magneten ausdehnen und sich in der Nähe der Magnete wieder zusammenziehen. Nachteilig ist hierbei indessen die aufwendige Einstrahlung der Mikrowellen mittels Hohlleitern oder dergleichen sowie die komplizierte Gestaltung der Dauermagnete.

Weiterhin ist ein Verfahren zum Herstellen dünner, dotierter Metallschichten durch reaktives Aufstäuben bekannt, bei dem ein Substrathalter und ein Targethalter mit einer Hochfrequenz-Hochspannungsquelle verbunden sind und bei dem zum Bestäuben eine Biasspannung im Bereich von -30 V bis -100 V, vorzugsweise -70 ± 10 V angelegt wird (DE-A-2 909 804). Hierbei geht es um die reproduzierbare Abscheidung von Widerstandsschichten mit genau definierten elektrischen Eigenschaften, wobei diese Schichten durch ein reines Dioden-HF-Sputtern hergestellt werden. Die Problematik des Arcing wird bei diesem bekannten Verfahren nicht berührt, weil elektrisch gut leitende Verbindungen abgeschieden werden und zudem keine Gleichspannungsversorgung verwendet wird.

Ferner ist auch eine Ionenstrahl-Materialbearbeitungsanlage mit Neutralisationseinrichtung bekannt, bei welcher Anschlüsse zum Anschluß einer elektrischen Spannung zwischen einem Probenhalter und/oder einem Target und der Neutralisationseinrichtung vorgesehen sind, wobei für diese elektrische Spannung eine Polarität als Saugspannung für den Transport von Elektronen dient (DE-A-3 511 141). Um undefinierte Ladungszustände auf dem zu bearbeitenden Substrat und/oder Target zu vermeiden, wird die Neutralisationseinrichtung in Form von thermisch emittierten Elektronen verwendet und zusätzlich eine gegenüber Masse positive Saugspannung am Substrat und/oder Target angelegt. Die Problematik des reaktiven Sputterns, insbesondere die reaktive Abscheidung von Dielektrika, wird hierbei nicht berührt.

Bei einem anderen bekannten Dioden-Verfahren zum Ätzen von Aluminium sind eine Gleichspannungsquelle und ein HF-Generator parallelgeschaltet und ihre gemeinsame Ausgangsspannung an zwei gegenüberliegende Elektroden gelegt (DE-A-3 140 675). Auch hier wird das Problem des reaktiven Sputterns durch Impulsübertragung nicht

angesprochen.

Der Erfindung liegt die Aufgabe zugrunde, bei einer herkömmlichen Magnetron-Sputteranlage, bei welcher die Feldlinien der Dauermagnete Toroide bilden, die durch das zu sputternde Material hindurchgreifen, die störenden Aufladungseffekte auf dem Target zu vermeiden.

Diese Aufgabe wird gemäß den Merkmalen des Patentanspruchs 1 gelöst.

Der mit der Erfindung erzielte Vorteil besteht insbesondere darin, daß eine weitgehend störungsfreie Abscheidung von Dielektrika, zum Beispiel $SiO_2$, $Al_2O_3$, $Si_3N_4$ oder AlN, mit hohen Raten durch reaktives Zerstäuben mit herkömmlichen Magnetronkathoden ermöglicht wird.

Alle Vorteile des reaktiven Gleichstrom-Sputterns bleiben erhalten, weil der überlagerte Hochfrequenzanteil die Potentialunterschiede auf dem Target abbaut, wodurch die störenden Aufladungseffekte auf dem Target vermieden werden, die ihrerseits dafür verantwortlich sind, daß die Entladung durch permanentes Arcing zum Erliegen kommt. Der Hochfrequenzanteil soll somit nicht wie beim Stand der Technik dazu dienen, daß erstens durch Erhöhung der Plasmadichte die Absputterrate gesteigert wird und zweitens die nichtleitenden Bereiche auf dem Target abgesputtert werden, sondern daß es auf den nichtleitenden Targetbereichen, welche sich beim reaktiven Magnetronsputtern unvermeidlich bilden, nicht zu störenden Aufladungseffekten kommt. Hierzu wird die Gleichspannung derart mit einer Hochfrequenzspannung moduliert, daß gerade die störenden Aufladungseffekte auf dem Target vermieden werden.

Ein Ausführungsbeispiel der Erfindung ist in der Zeichnung dargestellt und wird im folgenden näher beschrieben. Es zeigen:

Fig. 1 eine Prinzipdarstellung der erfindungsgemäßen Anordnung;

Fig. 2 eine graphische Darstellung der Abhängigkeit des Kathodenstroms von der Kathodenspannung sowie der Sputterrate über der Sputterleistung bei einem Druck von $7 \times 10^{-3}$ mbar bei einer bekannten Gleichstrom-Magnetron-Sputteranordnung;

Fig. 3 eine graphische Darstellung der Abhängigkeit des Kathodenstroms sowie eines $O_2$-Partialdrucks von der Gleichstrom-Kathodenspannung bei einem Argondruck von $7 \times 10^{-3}$ mbar, einem konstanten $O_2$-Fluß von 6,7 SCCM/min und bei einem Al-Target;

Fig. 4 eine graphische Darstellung der Abhängigkeit des Kathodenstroms und des $O_2$-Partialdrucks von der Gleichstrom-Kathodenspannung bei einem Argondruck von $7 \times 10^{-3}$ mbar, einem konstanten $O_2$-Fluß von 6,7 SCCM/min, einer überlagerten Hochfrequenzspannung mit einer Amplitude von 140 V und einem Al-Target;

Fig. 5 eine graphische Darstellung einer Gleichstrom-Kathodenspannung, der eine Wechselspannung überlagert ist;

Fig. 6 eine graphische Darstellung der Abhängigkeit des Kathodenstroms von der Kathodengleichspannung und von der Kombination aus Gleichspannung und überlagerter Wechselspannung in reiner Argonatmosphäre.

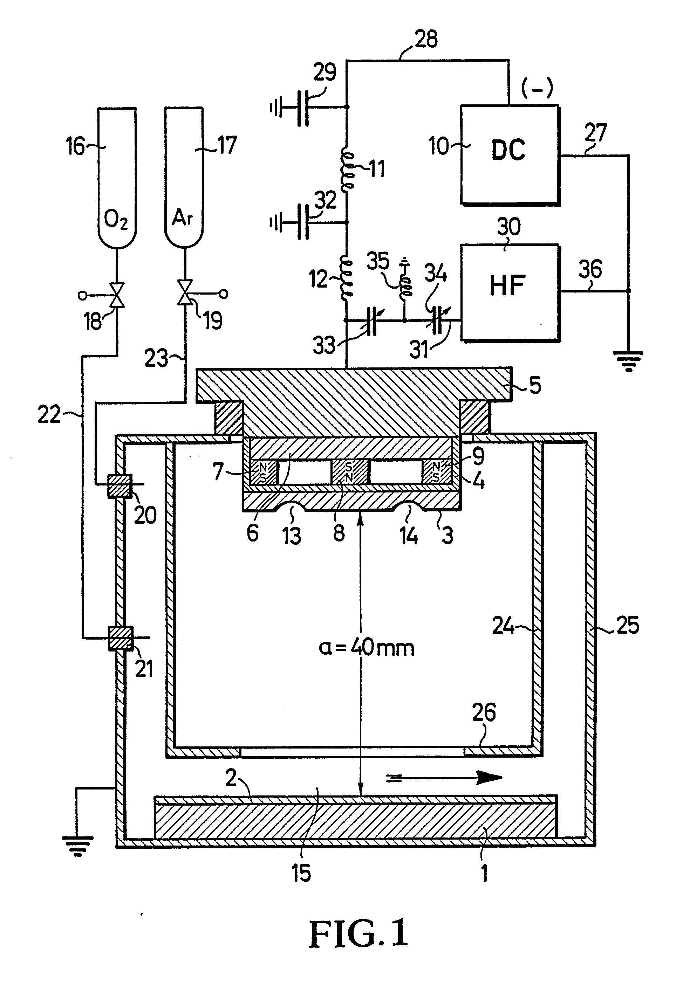

In der Fig. 1 ist ein Substrat 1 dargestellt, das mit einer dünnen Schicht 2 eines Dielektrikums versehen werden soll. Diesem Substrat 1 liegt ein Target 3 gegenüber, das zu zerstäuben ist. Das Target 3 steht über ein im Schnitt U-förmiges Element 4 mit einer Elektrode 5 in Verbindung, die auf einem Joch 6 ruht, welches zwischen sich und dem Element 4 drei Dauermagnete 7, 8, 9 einschließt. Die auf das Target 3 gerichteten Polaritäten der Pole der drei Dauermagnete 7, 8, 9 wechseln sich ab, so daß jeweils die Südpole der beiden äußeren Dauermagnete 7, 9 mit dem Nordpol des mittleren Dauermagneten 8 ein etwa kreisbogenförmiges Magnetfeld durch das Target 3 bewirken. Dieses Magnetfeld verdichtet das Plasma vor dem Target 3, so daß es dort, wo die Magnetfelder das Maximum ihres Kreisbogens besitzen, seine größte Dichte hat. Die Ionen im Plasma werden durch ein elektrisches Feld beschleunigt, das sich aufgrund einer Gleichspannung aufbaut, die von einer Gleichstromquelle 10 abgegeben wird. Diese Gleichstromquelle 10 ist mit ihrem negativen Pol über zwei Induktivitäten 11, 12 mit der Elektrode 5 verbunden. Das elektrische Feld steht senkrecht auf der Oberfläche des Targets 3 und beschleunigt die positiven Ionen des Plasmas in Richtung auf dieses Target. Hierdurch werden mehr oder weniger viele Atome oder Partikel aus dem Target 3 herausgeschlagen, und zwar insbesondere aus den Gebieten 13, 14, wo die Magnetfelder ihre Maxima haben. Die zerstäubten Atome oder Partikel wandern in Richtung auf das Substrat 1, wo sie sich als dünne Schicht 2 niederschlagen.

Handelt es sich bei dem Targetmaterial um ein Metall und soll auf dem Substrat eine Oxidschicht abgeschieden werden, so reagieren die aus dem Target 3 herausgeschlagenen Partikel in einem Raum 15 mit bestimmten Gasen, die aus Gasbehältern 16, 17 über Ventile 18, 19 und Einlaßstutzen 20, 21 mittels Gaszuführungsleitungen 22, 23 in diesen Raum 15 geleitet werden. Dieser Raum 15 wird durch zwei Behälter 24, 25 gebildet, von denen der eine Behälter 25 das Substrat 1 mitumfaßt, während der andere Behälter 24 vor dem Substrat 1 endet und eine Blende 26 bildet. Beide Behälter 24, 25 und damit auch das Substrat 1, das auf dem Boden des Behälters 25 ruht, liegen elektrisch auf Masse. An Masse liegt auch der zweite Anschluß 27 der Gleichstromquelle 10, deren erster Anschluß 28 außer an die Induktivitäten 11, 12 auch noch an einen Kondensator 29 angeschlossen ist, der seinerseits an Masse liegt.

Erfindungsgemäß ist nun außer der Gleichstromquelle 10 auch noch eine Hochfrequenzquelle 30 mit einem Anschluß 31 mit der Elektrode 5 elektrisch verbunden, und zwar über zwei regelbare Kondensatoren 33, 34, zwischen denen noch eine Induktivität 35 angeschlossen ist, die an Masse liegt. Der Verbindungspunkt der beiden anderen Induktivitäten 11, 12 ist an einen Kondensator 32 angeschlossen, der - wie auch der zweite Anschluß 36 der Hochfrequenzquelle 30 - ebenfalls an Masse liegt.

Die Kapazitäten 29 und 32 sowie die eingeschlossene Induktivität 11 bilden ein Tiefpaßfilter, das hohe Frequenzen am Durchtritt hindert. Die Induktivität 12 unterstützt noch diese Wirkung. Die Kapazitäten 33 und 34 sowie die Induktivität 35 bilden ein Anpassungsnetzwerk für die Hochfrequenzeinspeisung zur Kathode 5. Gleichzeitig wirken sie als Hochpaßfilter, d. h. die Gleichspannung kann nicht zur Wechselstromquelle 30 gelangen.

Das Gas gelangt bei der Anordnung gemäß Fig. 1 zwar in den Zwischenraum zwischen dem ersten und dem zweiten Behälter 25, 24, doch könnte es auch über ein die Kathode 5 umgebendes Gasverteilungssystem dem zweiten Behälter 24 zugeführt werden.

Für die Steuerung der in der Fig. 1 dargestellten Anordnung kann ein Prozeßrechner vorgesehen werden, der Meßdaten verarbeitet und Steuerungsbefehle abgibt. Diesem Prozeßrechner können beispielsweise die Werte des gemessenen Partialdrucks in der Prozeßkammer 25 zugeführt werden. Aufgrund dieser und anderer Daten kann er zum Beispiel den Gasfluß über die Ventile 18, 19 regeln und die Kombination aus Gleich- und Wechselspannung an der Kathode einstellen. Der Prozeßrechner ist auch in der Lage, alle anderen Variablen, zum Beispiel Kathodenstrom, Hochfrequenzleistung und magnetische Feldstärke zu regeln. Da derartige Prozeßrechner bekannt sind, wird auf eine Beschreibung ihres Aufbaus verzichtet.

In der Fig. 1 ist nicht im einzelnen dargestellt, wie die Hochfrequenz-Versorgung intern geregelt wird. Es ist jedoch bekannt, einen Regelkreis so aufzubauen, daß bei einer bestimmten Sollwertvorgabe die abgegebene Leistung auf diesen vorgegebenen Wert konstant geregelt wird.

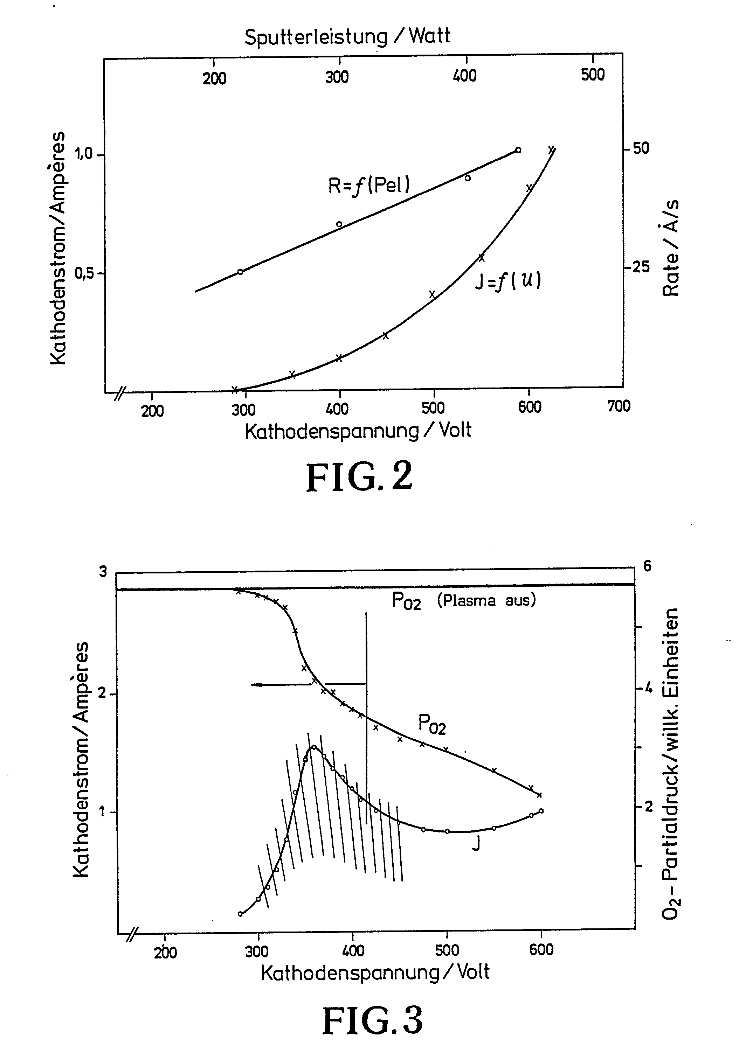

In der Fig. 2 sind die Vorgänge, die sich bei reinem Gleichstrom-Magnetron-Sputtern abspielen, graphisch dargestellt. Diese Vorgänge sind wichtig für das Verständnis der weiter unten beschriebenen Wirkungsweise der erfindungsgemäßen Anordnung. Man erkennt aus der Fig. 2, die sich auf eine reine Inertgasatmosphäre aus Argon und auf einen Gasdruck von $7 \times 10^{-3}$ mbar bezieht, daß der Kathodengleichstrom eine eindeutige Funktion der Gleich-Kathodenspannung ist und umgekehrt. Da der Widerstand mit zunehmender Spannung abfällt, was auf die Bildung eines leitfähigen Plasmas zurückzuführen ist, steigt der Strom $J = f(U)$ in etwa parabelförmig an. Die Sputterrate R, welche in Å/s ausgedrückt ist, nimmt linear mit zunehmender Sputterleistung zu, was durch die Gerade $R = f(P_{el})$ zum Ausdruck kommt. Bei 440 Watt, was einer Leistungsdichte von 10 Watt/cm$^2$ entspricht, beträgt die Rate 50 Å/s.

In der Fig. 3 sind die Abhängigkeit des Kathodenstroms von der Kathodenspannung sowie die Abhängigkeit zwischen dem $O_2$-Partialdruck und der Kathodenspannung im reinen Gleichstromfall und bei vorgegebenen Argon-und Sauerstoffflüssen dargestellt. Die Meßkurven der Fig. 2 wurden bei einem Massenfluß $f_{O_2}$ des Sauerstoffs von 6,7 SCCM/min = const aufgenommen, worin SCCM/min gleich Norm-Millilitern/min entspricht.

Im Gegensatz zur Darstellung der Fig. 2 handelt es sich also bei der Darstellung der Fig. 3 um die Verhältnisse bei reaktivem Gleichstromsputtern. Aus der Strom-Spannungs-Kennlinie ergibt sich, daß der Strom J bei zunehmender Spannung noch immer eine eindeutige Funktion dieser Spannung ist. Mit zunehmener Spannung steigt der Strom zunächst sehr steil an, erreicht dann ein Maximum und fällt von dort ab, um anschließend wieder etwas anzusteigen. Wird die Spannung jedoch, von hohen Spannungen um etwa 600 Volt, heruntergefahren, so nimmt der Strom zwar zunächst mit abnehmender Spannung ab, wenn ein vorwiegend metallischer Targetzustand vorausgesetzt wird, doch steigt der Strom bei weiterer Spannungsabnahme kräftig an, was auf die vermehrte Oxidbildung auf der Targetoberfläche zurückzuführen ist. Unterhalb von 350 Volt nimmt der Strom schnell wieder ab, verbunden mit einem kräftigen Anstieg des $O_2$-Partialdrucks. In dem Bereich von etwa 450 Volt und 350 Volt steigt die Sekundärelektronenausbeute des $Al_2O_3$, das sich auf dem Target niedergeschlagen hat, unter Argonionenbeschuß an. Dagegen wird im Bereich unterhalb von 350 Volt das Target mit $O_2$-Molekülen belegt, ohne daß sich auf dem Target $Al_2O_3$ bildet. Dieses $O_2$ wird durch auftreffende Argon-Ionen gesputtert, so daß der Sekundärelektroneneffekt reduziert wird. Nachteilig ist bei dem reaktiven Gleichstrombetrieb, daß ausgerechnet derjenige Kathodenspannungsbereich, in dem sich absorptionsfreie Schichten auf dem Subtrat bilden - also im Bereich von etwa 300 V bis 400 V -ein instabiler Bereich ist, in dem es nach einiger Zeit zum Arcing oder gar zum Plasmaausfall kommt. Der Arbeitspunkt muß deshalb schnell durchfahren werden, damit die Entladung nicht zum Erliegen kommt.

Wie bereits erwähnt, ist der Kathodenstrom J eine eindeutige Funktion der Kathodenspannung, d. h. zu jedem Spannungswert existiert genau ein Stromwert. Umgekehrt gilt dies jedoch nicht. Wenn man die beiden Achsen der Fig. 3 vertauscht und U auf der vertikalen und J auf der horizontalen Achse aufträgt, so beschreibt die Spannungskurve ein S, das bei einem Stromwert zwei Spannungswerte besitzt.

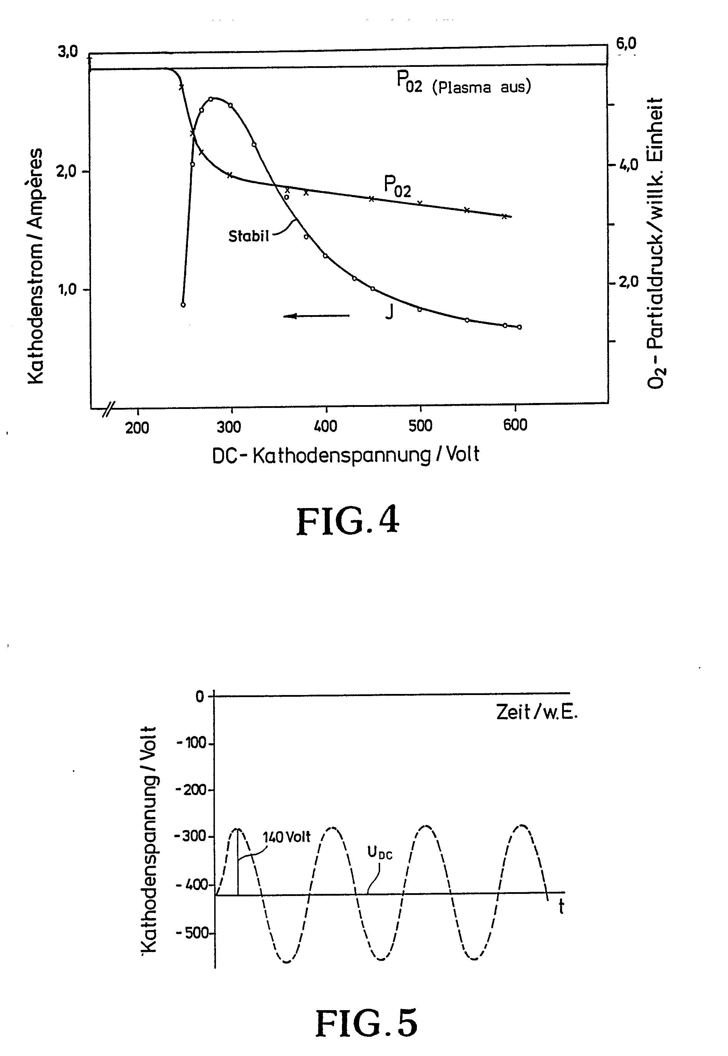

In der Fig. 4 sind der $O_2$-Partialdruck und der Entladestrom als Funktionen der Gleichstrom-Kathodenspannung unter denselben Bedingungen wie in der Fig. 3 dargestellt, jetzt allerdings für den Fall der hochfrequenzmodulierten Kathodenspannung. Die Modulationsfrequenz beträgt hierbei 13,56 MHz, die Hochfrequenzamplitude 140 Volt und die effektive Hochfrequenzleistung an der Kathode konstant 20 Watt. Absorptionsfreie $Al_2O_3$-Schichten erhält man unterhalb von 425 Volt, also ähnlich wie beim reinen Gleichstromfall der Fig. 3. Die Entladung ist jetzt aber völlig stabil und arcingfrei. Am Arbeitspunkt bei ca. 420 Volt wurde in Versuchen die Entladung mehrere Stunden betrieben, ohne daß es zu Überschlägen gekommen wäre. Zwischen 500 Volt und 360 Volt stimmen die Spannungs-Strom-Kennlinien der Fig. 3 und 4 bis auf wenige Prozent Abweichung gut überein. Der gegenüber der Fig. 3 in der Fig. 4 unterhalb von 360 Volt zu beobachtende weitere starke Stromanstieg ist so zu erklären, daß der Hochfrequenzanteil zunächst in der Lage ist, die Adsorption von $O_2$-Molekülen auf der Targetoberfläche zu verhindern, wodurch die vermehrte Sekundärelektronenausbeute nicht gestört wird. Mehr Sekundärelektronen führen zwar zu einer Erhöhung des Ionenstroms durch Stoßionisierung, aber in erster Linie zu einer scheinbaren Ionenstromerhöhung durch Erhöhung des Elektronenstroms weg von der Kathode. Durch diesen Effekt wird der Arbeitsbereich breiter, während sich die Sputterrate nur wenig mit abnehmender Spannung ändert, was am relativ geringen Anstieg des $O_2$-Partialdrucks zu sehen ist. Am Arbeitspunkt von 420 Volt beträgt die Rate für $Al_2O_3$ 25 Å/s bei einer Leistung von ca. 470 Watt, d. h. die Rate ist gegenüber der reinen Metallrate nur auf den halben Wert abgesunken. Unterhalb von 280 Volt nimmt der Strom stark ab, was auf die $O_2$-Belegung des Targets und die Abnahme des Sputtereffekts bei kleinen Spannungen zurückzuführen ist. Oberhalb von 500 V ist der Strom, der bei einer Spannung mit Hochfrequenzanteil fließt, geringer als im reinen Gleichstrom-Fall der Fig. 3. Offensichtlich hat hier die Hochfrequenzspannung einen Einfluß auf das Plasma.

In der Fig. 5 ist die modulierte Spannung dargestellt, die an der Elektrode 5 anliegt. Es handelt sich hierbei um eine Gleichspannung von -420 Volt, der eine Hochfrequenzspannung mit einer Amplitude von 140 Volt überlagert ist. Diese Spannung wird vorzugsweise dann angelegt, wenn der Argon-Druck in der Prozeßkammer 7 x $10^{-3}$ mbar beträgt und wenn Aluminium gesputtert und mit Sauerstoff oxidiert werden soll. Die effektive Hochfrequenzleistung wird auf 20 Watt eingestellt, und der Gleichstrom, der über die Elektrode 5 fließt, beträgt etwa 1,14 A.

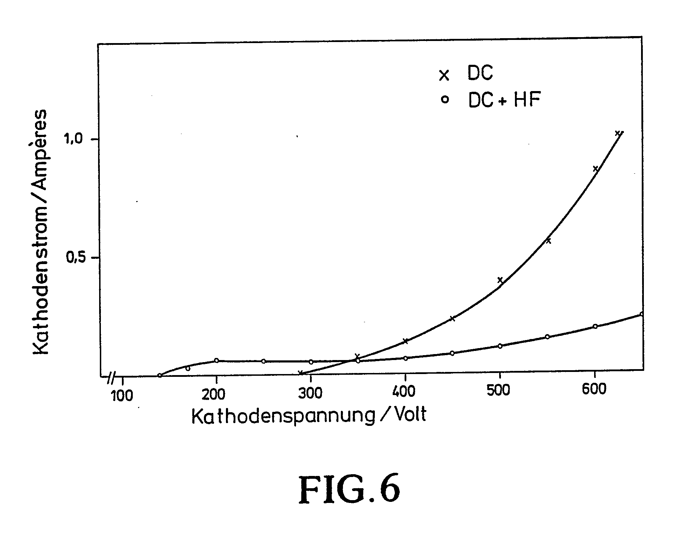

Der Einfluß der Hochfrequenz auf das Plasma ist deutlich in der Fig. 6 zu erkennen, die Strom-Spannungskennlinien bei einer reinen Argon-Atmosphäre zeigt. Die Kennlinie, deren gemessene Punkte durch ein Kreuz markiert sind, stellt die Strom-Spannungskennlinie bei reinem Gleichstrombetrieb dar, während die Kennlinie, deren gemessene Punkte durch einen Kreis markiert sind, die Strom-Spannungskennlinie bei einer modulierten Spannung wiedergibt. Die Hochfrequenzleistung an der Kathode 5 beträgt hierbei ca. 20 Watt. Diese effektiv wirksame Leistung wurde durch Vergleich der Absputterraten im reinen Gleichstromfall und im Hochfrequenzfall ermittelt. Aus der Fig. 6 sind zwei wesentliche Punkte zu erkennen: Ausgehend von typischen Leistungsdichten von 10 W/cm² für Gleichstrom-Magnetronentladungen - ca. 600 V/0,8A in Fig. 6 - sinkt der Gleichstrom-Entladestrom bei gleicher Gleichspannung schon bei 20 Watt überlagerter Hochfrequenzleistung, d. h. bei einer Modulationsamplitude von ca. 140 Volt sinkt der Strom auf nur 0,18 A ab.

Für eine magnetfeldunterstützte Gleichstrom-Magnetronentladung hat eine Hochfrequenzmodulation von ca. 5 % der ursprünglichen Gleichstromleistung bereits drastische Auswirkungen. Die Gleichstromleistung geht auf ca. 100 Watt = 2,3 Watt/cm² zurück. Offensichtlich stört das Hochfrequenz-Wechselfeld den vor der Kathode 5 kreisenden Elektronen-Driftstrom. Die Elektronen, die dem Hochfrequenz-Wechselfeld folgen können, werden im Mittel weiter von der Kathode 5 entfernt, was gleichbedeutend mit einer Abnahme ihrer Stoßwahrscheinlichkeit ist. Gekoppelt damit sind auch erhöhte Elektronendriftverluste.

Dieses Ergebnis steht im Widerspruch zu den Beobachtungen Vratnys (a.a.O.) bei reinem Dioden-Sputterbetrieb, wonach dann, wenn eine Diode mit einer hochfrequenzmodulierten Gleichspannung versorgt wird, eine deutliche Erhöhung des Gleichstrom-Entladestroms erfolgt. Die von Vratny angegebene HF-Leistung von ca. 200 Watt beträgt etwa 43 % der angegebenen Gleichstrom- und Hochfrequenzleistung. Ob es sich hierbei um die tatsächlich auf der Kathode wirksame Hochfrequenzleistung handelt, wird nicht gesagt.

Mit abnehmender Gleichstrom-Kathodenspannung nimmt in der Fig. 6 der Gleichstrom-Entladestrom mit Hochfrequenz-Modulation langsam weiter ab. Unterhalb von 350 V liegt der Gleichstrom-Entladestrom über dem Entladestrom für reine Gleichstrom-Entladung. Während die reine Gleichstrom-Entladung bei 290 V erlischt, geht der Gleichstrom-Anteil der HF-modulierten Entladung erst bei 140 V, dem natürlichen Gleichstrompotential der reinen HF-Entladung, auf Null zurück.

Im Magnetronfall ist also zwischen dem Gleichstrompotential der reinen Hochfrequenz-Entladung und dem Zündbereich der reinen Gleichstrom-Entladung im hochfrequenzmodulierten Gleichstrom-Fall eine Erhöhung des Gleichstrom-Stromanteils zu beobachten. In diesem Bereich, der für den reaktiven Prozeß von untergeordneter Bedeutung ist, ist die höhere Ionisierungswirkung von Hochfrequenz-Entladungen ausschlaggebend.

Die Ergebnisse und Beobachtungen, die Vratny (a.a.O.) beim reinen Diodensputtern gemacht hat, sind also prinzipiell mit diesem, für die vorliegende Erfindung weniger bedeutenden Effekt gekoppelt.

Der nur schwer vorhersehbare und eigentlich unerwünschte Effekt der Gleichstrom-Stromabnahme in weiten Bereichen der Gleichstrom-Magnetron-Entladung durch Hochfrequenz-Modulation geringer Leistung wird im reaktiven Betrieb durch die partielle Targetoxidation durch erhöhte Sekundärelektronenausbeute überkompensiert. Die Hohe dieses Effektes ist material-und gasartabhängig. Für Al, Si, Sn in Ar/$O_2$-Atmosphäre sowie Al und Si in Ar/$N_2$-Atmosphäre wurde dieser Effekt bereits durch Versuche festgestellt.

## Ansprüche

1. Anordnung zum Beschichten eines Substrats mit Dielektrika, die eine Gleichstromquelle aufweist, welche mit einer Elektrode verbunden ist, die elektrisch mit einem Target in Verbindung steht, das zerstäubt wird und dessen zerstäubte Teilchen mit einem zugeführten Stoff eine Verbindung eingehen, die sich auf dem Substrat niederschlägt, wobei toroidförmige Magnetfelder durch das Target hindurchgreifen, deren Feldlinien im Bereich der Magnetpole aus der Oberfläche des Targets austreten, **dadurch gekennzeichnet**, daß eine Wechselstromquelle (30) vorgesehen ist, deren Ausgangsspannung der Gleichspannung der Gleichstromquelle (10) überlagert ist, und daß die elektrische Leistung der Wechselstromquelle (30), die der Elektrode (5) zugeführt wird, 5 % bis 25 % der von der Gleichstromquelle (10) der Elektrode (5) zugeführten Leistung entspricht.

2. Anordnung nach Anspruch 1, **dadurch gekennzeichnet**, daß die Wechselstromquelle (30) eine Hochfrequenzstromquelle ist.

3. Anordnung nach den Ansprüchen 1 und 2, **dadurch gekennzeichnet**, daß die Hochfrequenzleistung 10 % der Gleichstromleistung beträgt.

4. Anordnung nach Anspruch 1, **dadurch gekennzeichnet**, daß die Gleichstromquelle (10) über zwei Induktivitäten (11, 12) an die Elektrode (5) angekoppelt ist.

5. Anordnung nach Anspruch 1, **dadurch gekennzeichnet**, daß die Wechselstromquelle (30) über Kondensatoren (33, 34) an die Elektrode (5) angekoppelt ist.

6. Anordnung nach Anspruch 4, **dadurch gekennzeichnet**, daß zwischen der Gleichstromquelle (10) und der ersten Induktivität (11) ein Kondensator (29) liegt, der an Masse angeschlossen ist.

7. Anordnung nach Anspruch 4, **dadurch gekennzeichnet**, daß zwischen der ersten Induktivität (11) und der zweiten Induktivität (12) ein Kondensator (32) liegt, der an Masse angeschlossen ist.

8. Anordnung nach Anspruch 1, **dadurch gekennzeichnet**, daß ein erster Behälter (25) vorgesehen ist, in dem sich ein zweiter Behälter (24) mit einer Öffnung befindet, die eine Blende (26) definiert, wobei das zu beschichtende Substrat (1) durch diese Öffnung des zweiten Behälters (24) hindurch dem Target (3) gegenüberliegt und wobei in den Zwischenraum zwischen dem ersten und dem zweiten Behälter (25, 24) eines oder mehrere Gase eingelassen werden.

9. Anordnung nach Anspruch 1, **dadurch gekennzeichnet**, daß die Wechselstromquelle (30) eine Wechselspannung von 13,56 MHz abgibt.

10. Anordnung nach Anspruch 1, **dadurch gekennzeichnet**, daß das Target (3) aus Aluminium und die auf dem Substrat abgeschiedene Schicht aus $Al_2O_3$ besteht.

11. Anordnung nach Anspruch 1, **dadurch gekennzeichnet**, daß das Target (3) aus dotiertem, d. h. leitfähigem Silizium und die auf dem Substrat abgeschiedene Schicht aus $SiO_2$ besteht.

12. Anordnung nach Anspruch 1, **dadurch gekennzeichnet**, daß das Target (3) aus Aluminium und die auf dem Substrat abgeschiedene Schicht aus AlN besteht.

13. Anordnung nach Anspruch 1, **dadurch gekennzeichnet**, daß das Target (3) aus dotiertem, d. h. leitfähigem Silizium und die auf dem Substrat abgeschiedene Schicht aus $Si_3N_4$ besteht.

14. Anordnung nach Anspruch 1, **dadurch gekennzeichnet**, daß die Gleichstromquelle (10) in Abhängigkeit von der Art des Targetmaterials strom-, spannungs- oder leistungsgeregelt betrieben wird.

15. Anordnung nach Anspruch 1, **dadurch gekennzeichnet**, daß die Gleichstromquelle (10) bei Verwendung eines Targets aus Al, Si oder Sn vorzugsweise spannungsgeregelt betrieben wird.

16. Anordnung nach Anspruch 1, **dadurch gekennzeichnet,** daß die Gleichstromquelle (10) beim Sputtern eines Targets (3) aus Al, Si, Sn, In/Sn in einer Argon/Sauerstoffatmosphäre spannungsgeregelt betrieben wird.

17. Anordnung nach Anspruch 1, dadurch gekennzeichnet, daß die Gleichstromquelle (10) beim Sputtern eines Targets (3) aus Al, Si in Argon/Stickstoffatmosphäre spannungsgeregelt betrieben wird.

FIG.1

FIG. 2

FIG. 3

FIG. 4

FIG. 5

EP 0 347 567 A2

FIG.6